# EUROPEAN PATENT APPLICATION

(11) **EP 1 496 510 A1**
(43) Date of publication of application: **12.01.2005**
(21) Application number: 03717595.7
(22) Date of filing: 15.04.2003
(51) Int. Cl.: G11B 7/26, G03F 7/26, G03F 7/004

(54) **STAMPER ORIGINAL AND ITS MANUFACTURING METHOD, STAMPER AND ITS MANUFACTURING METHOD, AND OPTICAL DISK**

(30) Priority: 15.04.2002 JP 2002111600; 02.08.2002 JP 2002226296
(71) Applicant: Nagase & Co., Ltd., Osaka 550-8668 (JP)
(72) Inventor: OGAWA, Shu, c/o NAGASE & CO., LTD., Tokyo 103-8355 (JP); YAMANAKA, Shojiro, c/o NAGASE & CO., LTD., Tokyo 103-8355 (JP); KOSHINO, Sadafumi, c/o NAGASE & CO., LTD., Tokyo 103-8355 (JP); MIYAKE, Koji, c/o NAGASE & CO., LTD., Tokyo 103-8355 (JP); SANO, Kazuhiko,, Kadoma-shi, Osaka 571-8501 (JP)
(74) Representative: von Kreisler Selting Werner
(86) International application number: PCT/JP2003/004789
(87) International publication number: WO 2003/088235

(57) **Abstract**

An object of the present invention is to provide a stamper preform and others capable of obviating an Ni electroforming step taking a long time and readily producing a defective in production of a stamper and capable of forming an accurate and fine pattern of projections and indentations. A stamper preform 11 of the present invention has a base 1, a semi-crosslinked resist layer 2, and a prebaked resist layer 3 stacked in this order. The prebaked resist layer 3 contains a methoxymethyl melamine and bumps are readily formed therein by exposure and development (Fig. 1C).

## Description

### BACKGROUND OF THE INVENTION

### Field of the Invention

The present invention relates to a stamper preform and a production method thereof, a stamper and a production method thereof, and an optical disk produced by the stamper.

### Related Background of the Invention

In general optical disks as recording media permitting recording of information are roughly classified under three types, a read only type, a write once type permitting only one recording, and a rewritable type permitting repetitive recording operations. In a 120mm DVD being an optical disk of the read only type, island projections or indentations called pits having the minimum length of about 0.400 µm and the height or depth of about 0.1 µm are formed on a base for optical disk. Such pits are formed on 47,000 tracks made on concentric circles in the optical disk, and in this case, the distance between tracks (track pitch) is 0.74 µm.

In such optical disks of the read only type (e.g., music CD, cinema DVD, etc.), recorded information is expressed by presence or absence of pits on the tracks. Therefore, such optical disks can be used as recording media simply in the form where pits are formed on the base, but it is common practice to form a reflecting layer of aluminum or the like on the surface, in order to increase the reflectance for readout light. For this reason, the base with pits formed thereon (molded product) is sometimes called an optical disk precursor.

On the other hand, an optical disk of the write once type is provided with a recording layer on a base, and the recording layer is generally comprised of a thin metal film, a thin organic dye film, or the like easy to evaporate. Information is recorded by projecting an optical beam onto the recording layer to form pits. The recorded information is expressed by presence/absence or lengths of pits on the recording layer.

Ditches for guiding the recording light such as the optical beam during recording are formed in the recording layer in the optical disk of the write once type (such ditches are called grooves and regions between ditches are called lands), and one groove and one land adjacent thereto constitute one track. The pits are formed on the grooves or on the lands.

Furthermore, an optical disk of the rewritable type is also provided with a recording layer as in the case of the write once type, and the recording layer is made of a recording material of the phase change type or the magnetooptical recording type. Information is recorded by projecting an optical beam onto the recording layer to form marks with different optical properties.

Grooves and lands are also formed in this optical disk of the rewritable type, and the marks are formed on the grooves or on the lands. In a rewritable DVD, for example, made of a recording material of the phase change type, the track pitch is designed to be about 0.615-0.74 µm.

In the write once and rewritable optical disks, information is recorded by projecting the recording light onto the recording layer in which the grooves and lands are preliminarily formed, and thereby forming pits or marks. For this reason, the object in the state in which the grooves and lands are formed in the recording layer (molded product) can be deemed as an optical disk precursor. An optical disk precursor with a groove material layer formed on a base is also known, and the precursor of this type is called a 2P (Photo Polymer) base. Here the "Photo Polymer" refers to photocurable resin.

In the optical disks of all the read only type, the write once type, and the rewritable type, as described above, fine projections and indentations such as pits and grooves are formed in these precursors. Therefore, the step of forming such projections and indentations is extremely important in the production of optical disks. One of the conventional methods of forming fine projections and indentations in the optical disk base is a method of transcribing projections and indentations onto the base or onto the recording layer by means of a template called a stamper.

In the method using the stamper, it is common practice to perform the transcription of projections and indentations onto the optical disk base at the time of molding. The molding can be carried out by well-known methods such as injection molding, cast molding, and press molding, and thus the method using the stamper is commonly used as a method of producing optical disks at low cost and in high volume. The stamper has been produced heretofore by the method as described below.

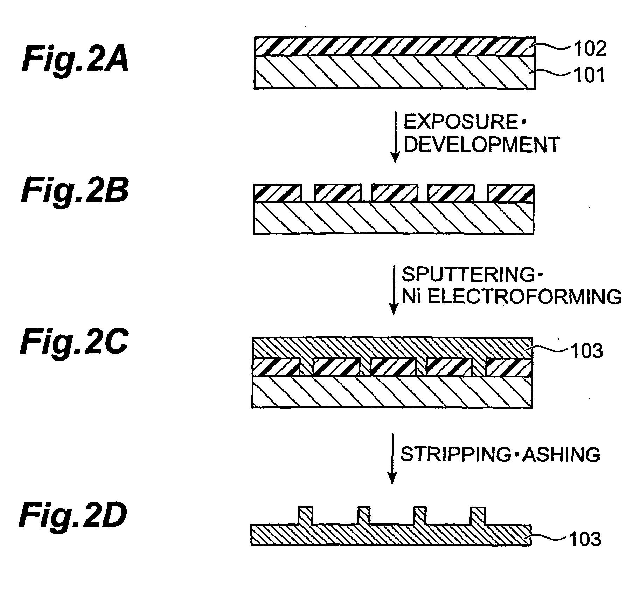

Figs. 2A to 2D are step diagrams schematically showing the conventional stamper production method. First, a positive photoresist is applied onto a base 101 to form a positive photoresist layer 102 (Fig. 2A: first step). Next, a laser beam is projected onto predetermined portions of the positive photoresist layer 102 to effect exposure thereof, and the positive photoresist layer is developed to remove the exposed portions, thereby forming a patterned positive photoresist layer (Fig. 2B: second step). The resulting object thus formed is called a resist master. Furthermore, an electroconductive layer is formed on the positive photoresist layer in the resist master by sputtering or by vacuum evaporation, and thereafter an Ni electroformed layer is formed by electroforming (Fig. 2C: third step; the electroconductive layer and the Ni electroformed layer will be referred to together as an Ni layer 103). Then the Ni layer 103 is stripped off from the base 101 having the patterned positive photoresist layer 102, and then the positive photoresist remaining on the surface of the Ni layer 103 after the stripping work is removed by ashing (dry etching with oxygen gas) to obtain a stamper (Fig. 2D: fourth step).

Besides the above method, there is also another known method of producing a glass stamper with a concave pattern by wet or dry etching on a glass master, as a stamper for injection molding or for 2P cast molding.

### SUMMARY OF THE INVENTION

The above-described conventional stamper production method tends to take a long time for all the steps in the stamper production because the electroconductive layer is formed by sputtering, vacuum evaporation, or the like and the Ni electroformed layer is formed by plating, in addition to the application of the photoresist, the exposure, and the development. In addition, among the steps, the plating step of forming the Ni electroformed layer is likely to produce a defective and, if a defective is made, all the steps have to be done again from a start.

Furthermore, there was the problem that the electroconductive layer and the Ni electroformed layer thus formed were easy to peel off from each other because of the difference in density between them. For this reason, there were cases where the electroconductive layer peeled off in the step of stripping the Ni layer or in the step of removing the remaining photoresist, to leave projections and indentations other than the objective pattern on the resultant stamper.

With increase in information volume in recent years, there are demands for optical disks enabling high-density recording in order to achieve further increase of capacity. In order to realize such high-density recording, it is necessary to implement achievement of finer lands and grooves for further narrowing the track pitch in the optical disks, and achievement of smaller pits or marks.

In the case where the grooves and pits are formed in the optical disks by the stamper, the projections and indentations are desirably formed finely and accurately in the stamper, in order to make the grooves and pits finer. However, the aforementioned conventional stamper production method had the problem as described below.

The known photoresists to be used in the exposure and development steps in forming the resist master in the production of the stamper include positive photoresists of a type in which photo-irradiated portions (exposed portions) are removed by development after exposure, and negative photoresists of a type in which non-irradiated portions (unexposed portions) are removed, and it is common practice to use a positive photoresist.

Such a positive photoresist is comprised of a novolak resin with phenolic hydroxyls, a naphthoquinone diazide, and so on, and possesses a property that it is developed with an alkali solution. The photoresists of the alkali development type are free of swelling due to absorption of water or the like and permit only the exposed portions to be accurately removed in the development. By this, the patterning of the resist can be carried out with high processing accuracy.

However, in cases where in the formation of the resist master the patterning is carried out so that the width of regions of the resist to be removed is larger than that of regions not to be removed, the light needs to be projected onto a wide range during the exposure. This required increase in the spot diameter of the light to be projected.

The increase in the spot diameter of the projected light results in dispersion of energy of the spot light and, particularly, in decrease in energy near the periphery of the spot. In this case, the energy becomes too low near the periphery of the spot of the projected light to effect sufficient curing of the photoresist in this region, and this makes the boundary unclear between an exposed portion and an unexposed portion. This caused difficulty in accurately forming the projections and indentations of the stamper.

The present invention has been accomplished in view of such circumstances, and an object of the present invention is to provide a stamper preform and a production method thereof capable of eliminating the Ni electroforming step taking the long time and readily causing a defective in the production of the stamper and capable of accurately forming a pattern of fine projections and indentations. Another object of the present invention is to provide a stamper obtained by use of such a preform, and a production method thereof and to provide an optical disk in which a pattern (an information recording pattern) is transcribed by the stamper.

In order to achieve the above object, a stamper preform of the present invention comprises: a base; and a semi-crosslinked resist layer, and a prebaked resist layer comprising a compound represented by Formula (1) below, which are provided on the base.

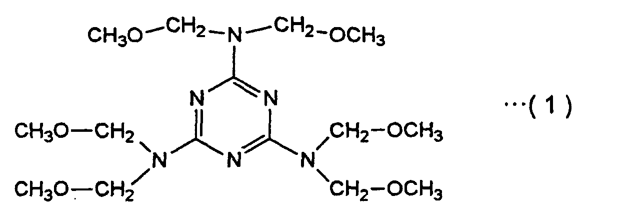

The prebaked resist layer is patterned by exposure and development and thereafter substantially completely crosslinked to form bumps for transcription of pits and grooves to optical disks. The bumps are formed of methoxymethyl melamine resin resulting from the crosslinking of the compound represented by Formula (1) above, and thus have high strength and adequate durability to such conditions as high temperature and high pressure. Therefore, a stamper produced by use of the stamper preform of the present invention comes to have sufficient strength and durability under production conditions for optical disks.

Since the prebaked resist layer is formed on the semi-crosslinked resist layer, the bumps formed are bonded through a hardened material of the semi-crosslinked resist layer to the base. Since the bumps and the hardened material of the semi-crosslinked resist layer both are made of resin, they demonstrate high adhesion and this makes peeling of the bumps from the base or the like very unlikely to occur.

The stamper produced from the stamper preform of the present invention as described above is equivalent to the resist master used as a template in the electroforming of Ni in the stamper production method of the conventional technology, but the bumps formed have high strength and durability as described above. Therefore, it can be used as a stamper in an as-produced state. Accordingly, the stamper preform of the present invention can obviate the need for the electroforming step of Ni or the like used to be needed after production of the resist master.

Furthermore, in use of the stamper preform of the present invention, a pattern formed by exposure and development serves as bumps of the stamper as it is, and it is thus feasible to form the bumps in a finer and highly accurate pattern, as compared with the conventional technology involving the further step of electroforming after the patterning.

Specifically, the semi-crosslinked resist layer and the prebaked resist layer are preferably stacked in the order named from the base side. The prebaked resist layer preferably further comprises a pigment having a property of absorbing light in a wavelength region of 635 to 650 nm. Furthermore, a protective film may be provided on the prebaked resist layer.

A stamper preform production method according to the present invention is a method for effectively producing the stamper preform of the present invention, which comprises a step of polishing or cleaning at least one surface of a base; a step of forming a semi-crosslinked resist layer on the one surface thus polished or cleaned; and a step of forming a prebaked resist layer comprising a compound represented 'by Formula (1) above, on the semi-crosslinked resist layer.

In this production method, a step of further forming a protective film on the prebaked resist layer may be further carried out after execution of the step of forming the prebaked resist layer.

Furthermore, a stamper of the present invention is one substantialized by use of the stamper preform of the present invention, and comprises a base, and a bump provided on the base and comprising as a monomer unit a compound represented by Formula (1) above.

Moreover, a stamper production method according to the present invention is a method of effectively producing the stamper of the present invention, which comprises a step of recording given information in a prebaked resist layer in a stamper preform comprising a base, and a semi-crosslinked resist layer, and the prebaked resist layer comprising a compound represented by Formula (1) above, which are provided on the base; a step of developing the prebaked resist layer with the information recorded therein to form a bump; and a step of inducing a crosslinking reaction in the semi-crosslinked resist layer and in the bump to substantially completely cure the semi-crosslinked resist layer and the bump.

The present invention further provides an optical disk in which given information is transcribed by use of a stamper comprising a base, and a bump provided on the base and comprising as a monomer unit a compound represented by Formula (1) above.

### BRIEF DESCRIPTION OF THE DRAWINGS

Figs. 1A to 1E are step diagrams schematically showing a stamper production method according to the present invention.
Figs. 2A to 2D are step diagrams schematically showing a conventional stamper production method.
Fig. 3 is a sectional view showing an embodiment of an optical disk according to the present invention.

### DESCRIPTION OF THE PREFERRED EMBODIMENTS

Embodiments of the present invention will be described below in detail with reference to the drawings. The same elements will be denoted by the same reference symbols, without redundant description.

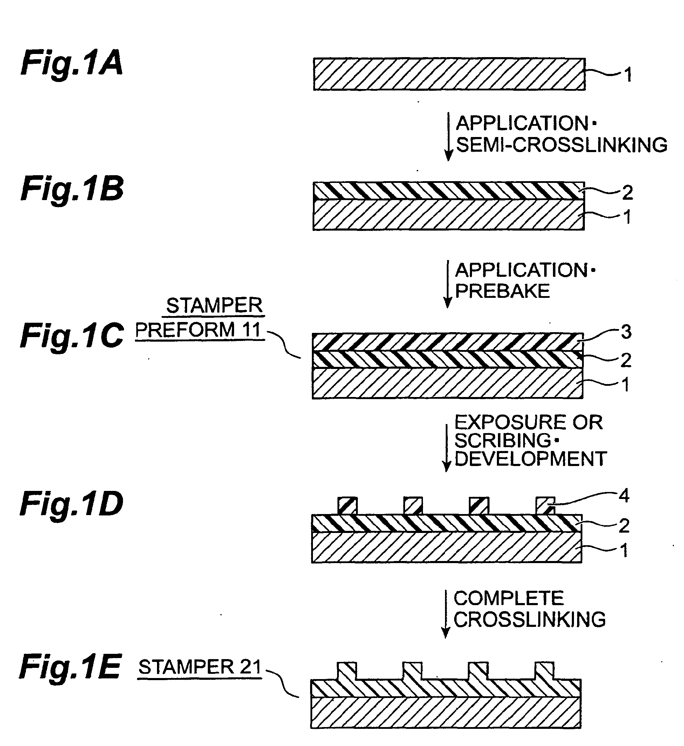

A stamper preform 11 of the present embodiment has a base 1, a semi-crosslinked resist layer 2 provided on this base 1, and a prebaked resist layer 3 provided on this semi-crosslinked resist layer 2 and containing a methoxymethyl melamine resin represented by Formula (1) below (cf. Fig. 1C).

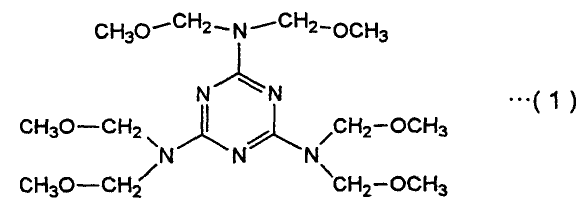

Here the term "semi-crosslinked" in the present invention refers to a state including a noncrosslinked resin prior, to complete crosslinking and curing of a monomer component forming a chemical amplification type resin (also including a component existing in a monomer state). The term "prebaked" refers to a state in which a layer formed is stabilized by a baking process with an oven or a hot plate or the like to evaporate a remaining solvent in liquid matter for formation of the prebaked resist layer 3.

Examples of a material to make the base 1 include metal, glass, silica, ceramics, synthetic resin, and so on. Examples of the metal include nickel, aluminum, titanium, stainless steel, tungsten, chromium, or alloys thereof, and so on, and Ni is commonly used.

There are no specific restrictions on the thickness of the base 1 as long as the thickness of resultant optical disks falls within the range of specifications. For example, in a case where the optical disks are molded by injection molding, the thickness of the base 1 is preferably 230-330 µm, and more preferably 280-300 µm.

Since projections and indentations are transcribed onto an optical disk base by the stamper simultaneously introduced into a mold during the injection molding, the thickness of the optical disk base relatively varies according to the thickness of the base 1 in the stamper. Therefore, if the base 1 is thinner than 230 µm, the optical disk base obtained tends to become thicker than the specifications of 1.2 mm ± 0.05 mm. If the base 1 is thicker than 330 µm, the thickness of the optical disk base obtained tends to become thinner than the specifications.

The semi-crosslinked resist layer 2 provided on the base 1 is a layer made of a material that undergoes a crosslinking reaction by heat and/or a light beam, and semi-crosslinked by irradiating the material with heat and/or a light beam. Examples of the material include negative photoresists, positive photoresists, epoxy thermosetting resin materials, acrylic thermosetting resin materials, melamine resin materials, and so on. Particularly, alkali-soluble negative photoresists are preferably applicable in view of compatibility with the prebaked resist layer 3 described later and work environmental issues.

The alkali-soluble negative photoresists include compounds with phenolic hydroxyls and examples thereof include novolak resins such as phenol novolak resins and cresol novolak resins, homopolymers of p-vinyl phenol or p-phenol maleimide, and copolymers of these. These alkali-soluble negative photoresists are preferable because they cause no adverse effect on human bodies and others during works.

Materials also applicable in addition to those described above include resists containing a methoxymethyl melamine compound represented by Formula (1) below, in view of the compatibility with the after-described prebaked resist layer 3, and two or more of such materials and the aforementioned materials may be used in combination.

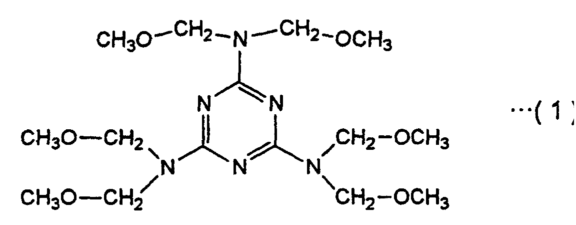

The methoxymethyl melamine compound represented to above Formula (1) is considered to create crosslinks, based on reaction between methoxymethyl groups included in its molecules or based on reaction between methoxymethyl groups and other components in the semi-crosslinked resist layer 2 to bind together. In this case, the semi-crosslinked state in formation of the semi-crosslinked resist layer 2 refers to a state in which some of six methoxymethyl groups in the methoxymethyl melamine compound react to form crosslinks. The semi-crosslinked resist layer 2 formed in this manner is in a state in which it demonstrates little solubility to a developer.

This semi-crosslinked resist layer 2 is provided for enhancing the adhesion strength between the base 1 and the prebaked resist layer 3 described later. Therefore, the thickness of the semi-crosslinked resist layer 2 is preferably in a range where it can hold sufficient adhesion strength. Specifically, the thickness is preferably 50-300 nm, and more preferably 100-150 nm. If the thickness of the semi-crosslinked resist layer 2 is smaller than 50 nm, the adhesion strength with the prebaked resist layer 3 will be inadequate and its shape can be damaged in molding of optical disks. If the thickness is larger than 300 nm, there will appear no further improvement in adhesion strength and it will result in wasting the resist and tending to increase the production cost of the stamper.

The material to make the prebaked resist layer 3 can be any material that is prebaked by heat, and in the present invention it is most preferably a methoxymethyl melamine compound represented by Formula (1) below, in terms of compatibility with the aforementioned semi-crosslinked resist layer 2, formability of resist bumps 4 in production of the stamper described later, the strength and durability of resist bumps 4 formed, and security during works.

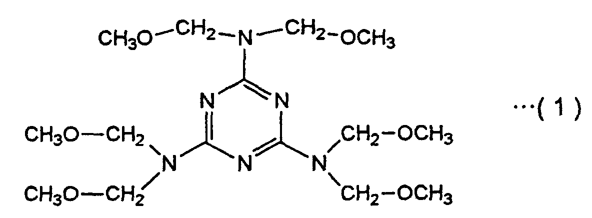

Examples of materials other than the methoxymethyl melamine compound represented by above Formula (1) include negative photoresists, positive photoresists, electron beam resists, and so on, and alkali-soluble negative photoresists are preferably applicable. In addition, it is also preferable to use the same material as the material used for the aforementioned semi-crosslinked resist layer 2, in terms of adhesion. Two or more of these materials may also be used in combination.

The prebaked resist layer 3 is formed in such a manner that one of these materials to be prebaked by heat is applied onto the aforementioned semi-crosslinked resist layer 2 and that thereafter it is prebaked to remove a solvent or the like mixed on the occasion of the application, and goes into a low flowability state. Where the material for the prebaked resist layer 3 is the aforementioned methoxymethyl melamine compound, it is considered that the aforementioned crosslinking reaction of methoxymethyl groups does not take place on the occasion of the prebaking, but no problem will arise even if the prebaking induces slight crosslinking reaction without degrading the solubility in a developer.

The thickness of the prebaked resist layer 3 may be determined so that the thickness of the optical disk base obtained falls within the range of specifications, as in the case of the aforementioned base 1, and it can be properly adjusted according to the specifications for respective optical disks. For example, in the case of DVD, the thickness of the prebaked resist layer 3 is preferably 100-300 nm, and more preferably 150-250 nm.

The prebaked resist layer 3 may contain an ingredient other than the above and, for example, it preferably contains a pigment or the like for the purpose of carrying out inspection for characteristics of electric signals or the like after formation of the stamper. Normally, it is necessary to inspect states of bumps in the resultant stamper, after production of the stamper. Such inspection is carried out commonly using stamper reproduction equipment capable of observing states of projections and indentations under irradiation with light.

Where the resist bumps 4 in the stamper obtained by use of the stamper preform 11 are unpigmented or transparent, reproduction light from the stamper reproduction equipment passes therethrough, so that the inspection tends to be hard with the use of the stamper reproduction equipment. In contrast to it, where a pigment or the like having the absorption property in the wavelength region of the reproduction light is included in the resist, the resist is provided with the property of absorbing the reproduction light and it becomes extremely easy to carry out the inspection on the resist bumps 4.

More specifically, since the conventional stamper reproduction equipment often used is one to project the reproduction light of the wavelength of 635 nm or 650 nm, the pigment included in the prebaked resist layer 3 is preferably one having the property of absorbing light in the wavelength region of 635 to 650 rm. In this case, the prebaked resist layer 3 tends to display deep green or a color close thereto.

Furthermore, the pigment is preferably one having heat resistance not to undergo any change during production of the stamper or during production of optical disks (approximately at 250°C), and is more preferably one with excellent solubility in the material making the prebaked resist layer 3.

Next, a stamper production method according to the present invention will be described on the basis of Figs. 1A to 1E. As shown in Figs. 1A to 1E, first, at least one surface of the base 1 is polished or cleaned in order to remove small flaws on the surface of the base 1 (Fig. 1A).

Examples of the polishing include mechanical polishing with an abrasive such as cerium oxide (CeO₂), chemical polishing with a chemical, electrolytic polishing, electroless polishing, physical polishing such as sputtering, and so on, one of which can be optionally selected according to the base to be polished. The cleaning is carried out for removing the ground powder and others made in the polishing and can be carried out by one of well-known methods.

Next, a material to induce the crosslinking reaction by heat and/or a light beam is applied onto the polished or cleaned surface of the base 1, so as to form the semi-crosslinked resist layer 2. The application can be carried out by properly selecting a preferred method out of the well-known methods such as spin coating, spraying, roll coating, and dipping. An appropriate coupling agent may be preliminarily applied onto the surface to be coated, for the purpose of enhancing the adhesion between the semi-crosslinked resist layer 2 and the base 1.

After the material to induce the crosslinking reaction with heat and/or a light beam is applied onto the base 1 in this manner, it is exposed to heat or a light beam to induce the crosslinking reaction to such an extent that the material is not completely crosslinked, thereby forming the semi-crosslinked resist layer 2 (Fig. 1B). The heating can be carried out by use of an oven, a hot plate, or the like and under such temperature and time conditions as not to complete the crosslinking reaction. The crosslinking by irradiation with a light beam can be implemented, for example, by the UV curing method and conditions for the irradiation are properly set so as not to cause complete crosslinking.

In a case where the material for formation of the semi-crosslinked resist layer 2 is a methoxymethyl melamine compound represented by foregoing Formula (1) and is semi-crosslinked by heat, the heating is carried out under such conditions that the temperature is preferably 70-250°C, more preferably 80-200°C and that the period of time of heating is preferably 10 seconds to 20 minutes, more preferably 20 seconds to 10 minutes.

In the case of semi-crosslinking by irradiation with a light beam, the irradiation is carried out under such conditions that the light beam has the wavelength preferably in the wavelength range of 200 to 450 nm, more preferably in the wavelength range of 250 to 360 nm and that the period of time of irradiation is preferably 10 seconds to 20 minutes, more preferably 20 seconds to 10 minutes. However, these conditions can be modified depending upon the thickness of the base 1, the thickness of the material to be applied, or a type of a heating unit or the light beam.

After completion of the formation of the semi-crosslinked resist layer 2, a resist material for formation of the prebaked resist layer 3 is applied thereonto by one of well-known means such as spin coating, spraying, roll coating, and dipping and is further heated by use of an oven or a hot plate to be prebaked so as to form the prebaked resist layer 3 (Fig. 1C), thereby obtaining a stamper preform 11.

Where a material containing a methoxymethyl melamine compound represented by aforementioned Formula (1) is used as a resist material for forming the prebaked resist layer 3, the prebake is carried out by heating preferably at 80-100°C, more preferably at 85-95°C and preferably for 70 seconds to 15 minutes, more preferably for 80 seconds to 12 minutes. However, these conditions can be arbitrarily modified according to the thickness of the base 1, the thickness of the semi-crosslinked resist layer 2, the thickness of the resist layer applied, and a type of a heating unit to be used.

Where the prebaked resist layer 3 is made to further contain another ingredient such as the aforementioned pigment, the ingredient is preferably made to be included in the resist material, prior to the application of the resist material.

A protective film may be provided on the prebaked resist layer 3 in the obtained stamper preform 11, if necessary, in order to prevent contamination of the layer with chemical substances and fungi existing in the natural environment. Examples of materials to be used for the protective film include polyvinyl alcohol, polymethyl methacrylate, silicone resin, polyurethane, and epoxy resin.

The protective film is preferably a material having sufficient transparency to the wavelengths of irradiation light used in the exposure described later and possessing the property of being dissolved in a developer in the development described later. An example of this material is polyvinyl alcohol. These materials to make the protective film may further contain additives such as an anti-fungus agent, a bactericide, and a surfactant. The protective film can be formed on the prebaked resist layer 3 by appropriately selecting one of the well-known methods such as spin coating, spraying, and roll coating.

Then the prebaked resist layer 3 in the stamper preform 11 obtained is exposed, for example, to the g-line, the i-line, light from a light source such as an Ar laser, Kr laser, ArF laser, KrF laser, or F₂ laser, X-rays, an electron beam, or the like to effect exposure, thereby forming a predetermined pattern. For example, where optical disks to be produced by use of the stamper are DVDs, it is preferable to irradiate the prebaked resist layer 3 with the light beam in the wavelength region of 351 to 413 nm.

After the exposure of the prebaked resist layer 3, unexposed portions are removed (by development) to form resist bumps 4 (bumps) in a given pattern of projections and indentations (given information) (Fig. 1D). The development can be carried out with an alkali developer.

Examples of the developer include inorganic alkali aqueous solutions such as sodium tertiary phosphate and sodium hydroxide, tetraalkylammonium hydroxide aqueous solutions such as tetramethylammonium hydroxide (TMAH), organic alkali solutions such as ethylene diamine and triethylamine, and so on. The concentration of the developer and the development conditions can be optionally set according to the type of the developer to be used.

In a case where a resist containing a methoxymethyl melamine compound represented by aforementioned Formula (1) is used for the prebaked resist layer 3, the developer is preferably a TMAH solution and, in this case, the alkali concentration thereof is preferably 0.4-2.5 wt%. The temperature of the developer is preferably ordinary temperature and the period of time of development is preferably 30-90 seconds.

After the resist bumps 4 are formed in this manner, the semi-crosslinked resist layer 2 and the resist bumps 4 are subjected to a process such as heating and/or irradiation with a light beam, whereby these are substantially completely crosslinked to be cured, thus obtaining a stamper 21 of the present invention (Fig. 1E). The heating process can be carried out by use of an oven, a hot plate, or the like, and the irradiation process with a light beam can be carried out by the UV curing method.

Where the material of the prebaked resist layer 3 is the foregoing methoxymethyl melamine compound, crosslinks are formed by reaction of methoxymethyl groups as described above. In this case, the substantially completely crosslinked state is a state in which more methoxymethyl groups form crosslinks than those in the semi-crosslinked state, and is preferably a state in which the major part of the methoxymethyl groups form crosslinks. Then the resist bumps 4 formed by the complete crosslinking are hardly soluble in the developer and are substantially insoluble.

In the case of the heating process, baking is preferably carried out in multiple stages between 175°C and 250°C, thereby substantially completely crosslinking the semi-crosslinked resist layer 2 and the resist bumps 4. In the case of the irradiation process with a light beam, the light beam preferably having the wavelength in the region of 200 to 450 nm, more preferably 250 to 360 nm, is projected preferably for 10 seconds to 20 minutes, more preferably 20 seconds to 10 minutes, thereby substantially completely crosslinking the semi-crosslinked resist layer 2 and the resist bumps 4. It is sufficient to carry out at least one of the heating process and the irradiation process with a light beam, but it is preferable to carry out the both processes in order to securely complete the crosslinking. However, these conditions can be optionally modified according to the thickness of the base 1, the thickness of the semi-crosslinked resist layer 2, the thickness of the resist bumps 4, the heating unit to be used, and so on.

Since the stamper 21 produced in this manner has the resist bumps 4 made of the methoxymethyl melamine resin resulting from the crosslinking of the prebaked resist layer 3, it demonstrates excellent strength and durability.

Since the stamper 21 produced from the stamper preform 11 of the present invention is made in such a manner that the base 1 and the resist bumps 4 are joined through the cured material of the semi-crosslinked resist layer 2 made of the resin material, adhesion is dramatically enhanced between the layers. Therefore, the strength and durability of the stamper 21 can be further improved. When compared with a case where the bumps are directly formed on the base, the resist bumps 4 can be prevented from peeling off from the base 1.

Thanks to these, the stamper 21 with the resist bumps 4 formed therein is able to perform the formation of pits and grooves (transcription of information) well even in the molding of optical disk bases necessitating high temperature and high pressure conditions. Even if the stamper is repeatedly used plural times, it will rarely suffer deterioration with time such as deficiency of the resist bumps 4 and peeling-off thereof from the base 1.

The stamper 21 corresponds to the resist master having been used as a template for Ni electroforming in the conventional stamper production method. Namely, the conventional production method further needed the electroforming step taking the long time and readily producing a defective, after the formation of the resist master, whereas the use of the stamper preform 11 of the present invention makes it feasible to obviate the need for the electroforming step. Therefore, the present invention enables production of the stamper in a short time and largely increase the yield.

Furthermore, the Ni electroforming is carried out by plating, and a waste such as a plating solution used is normally made after the plating process. Therefore, such electroforming is not environmentally preferable and required cost for a waste treatment. In contrast to it, the stamper preform 11 of the present invention produces no waste from plating, and it is thus feasible to realize a desired method achieving not only reduction of cost but also environmental care.

Moreover, the conventional stamper production method required the multi-stage steps for formation of projections and indentations in the stamper; i.e., the exposure and development of the resist were once carried out as described above to obtain the resist master and then the Ni electroforming was further carried out using it as a template. In contrast to it, the stamper production method according to the present invention enables the formation of projections and indentations by the exposure and development steps only. Therefore, patterning by exposure is accurately reproduced in the stamper 21. As a result, it is feasible to adequately relieve degradation of processing accuracy even in micropatterning.

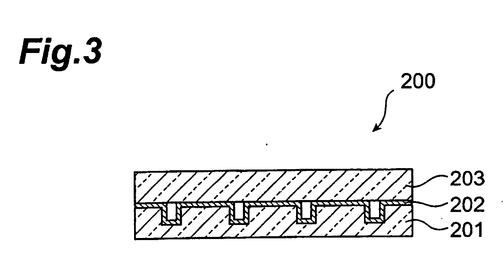

An optical disk can be obtained by transcribing given information onto an optical disk base by use of the stamper 21 having such excellent characteristics. Fig. 3 is a sectional view showing an embodiment of an optical disk of the present invention. The optical disk 200 is comprised of an optical disk base 201 with pits formed therein, a reflecting layer 202 formed on this base, and a dummy base 203 formed on this reflecting layer, and the pits formed on the base are those formed by transcription through the use of the aforementioned stamper 21 of the present invention.

A material for making the optical disk base 201 may be one having transparency (a light transmitting property) to light for readout of a record in the optical disk, and can be, for example, polycarbonate. The reflecting layer 202 is made, for example, of aluminum or the like and is provided in order to increase the reflectance for the readout light. Furthermore, the dummy base 203 is for protecting the base with the pits or the reflecting layer, and is preferably made of the same material as the base 201.

The optical disk 200 of this type is produced by transcribing given,information onto the optical disk base 201 or onto a recording layer formed on the base, using the aforementioned stamper 21 of the present invention. At this time, the transcription can be performed at the time of molding of the optical disk. Examples of the molding include the well-known methods such as injection molding, cast molding, and press molding, and it is common practice to adopt the injection compression molding. The molding conditions can be optionally determined according to the type of the optical disk to be molded (DVD, CD, or the like). Preferably, a surface of the base 1 in the stamper 21 set in place on a mold is polished because such trouble as a drop of the stamper 21 from the mold during the molding becomes unlikely to occur.

### [Examples]

### (Example 1)

### <Production of Stamper Preform>

First, one surface of an Ni base with the outside diameter of 200 mm and the thickness of 0.3 mm was mechanically polished using cerium oxide (CeO₂). Then an alkali-soluble negative resist containing a compound represented by Formula (1) below (NNR600S2, available from Nagase ChemteX Corporation) was applied in the thickness of 200 nm onto the polished surface of the Ni base by a spin coater.

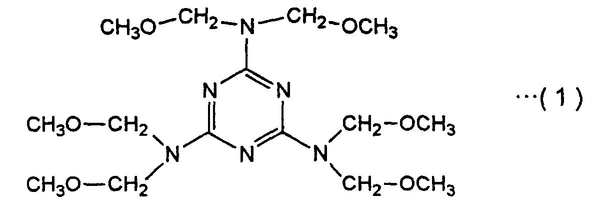

After the application, the resist was treated in a hot plate set at 110°C, for two minutes to be thermally crosslinked, and, after/before the heating, the resist was exposed to UV light to be optically crosslinked, thereby forming a semi-crosslinked resist layer. Then an alkali-soluble negative resist containing a methoxymethyl melamine resin represented by foregoing Formula (1) (NNR600S2, available from Nagase ChemteX Corporation) was applied in the thickness of 200 onto the top surface of the semi-crosslinked resist layer by a spin coater and thereafter it was prebaked in an oven set at 85°C, for ten minutes to form a prebaked resist layer, thereby producing a stamper preform.

### (Example 2)

### <Production of Stamper>

The prebaked resist layer of the stamper preform obtained was irradiated in a predetermined pattern with an Ar laser (351 nm) to record given information, and thereafter it was baked in a hot plate set at 110°C, for four minutes. Then a spin development was carried out at ordinary temperature (about 24°C) for sixty seconds with a 1.57wt% TMAH aqueous solution to remove exposed portions, thereby forming resist bumps. Then the stamper preform with the resist bumps formed therein was subjected to multi-stage baking consisting of a treatment in a hot plate at 175°C for ten minutes and a subsequent treatment in a hot plate at 250°C for ten minutes. Furthermore, deep UV light was used to completely crosslink the semi-crosslinked resist layer and the resist bumps. Then the stamper preform was punched into a doughnut shape having the outside diameter of 138 mm and the inside diameter of 22 mm, thus producing a stamper.

### (Example 3)

### <Production of Optical Disk>

A polycarbonate resin was used as a material for the optical disk base. The stamper obtained in Example 2 above was mounted on a mold, and the injection compression molding was carried out to obtain an optical disk base in the outside diameter of 120 mm and the inside diameter of 15 mm in which the information pattern recorded in the stamper was transcribed. Then aluminum sputtering was effected on the information pattern transcribed surface in the optical disk base to form a reflective film. Furthermore, a polycarbonate dummy base in the same size as the optical disk base was bonded onto the reflective film with an adhesive, thus producing an optical disk.

As described above, the stamper preform and the production method thereof, the stamper and the production method thereof, and the optical disk with the pattern transcribed by the stamper according to the present invention obviate the need for the Ni electroforming step taking the long time and readily producing a defective in the production of the stamper and enable formation of an accurate and fine pattern of projections and indentations.

## Claims

1. A stamper preform comprising:
a base; and
a semi-crosslinked resist layer, and a prebaked resist layer containing a compound represented by Formula (1) below, which are provided on the base.

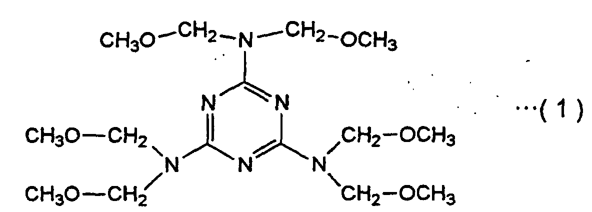

2. The stamper preform according to Claim 1, wherein the semi-crosslinked resist layer and the prebaked resist layer are stacked in the order named from the base side.

3. The stamper preform according to Claim 1, wherein the prebaked resist layer contains a pigment having a property of absorbing light in a wavelength region of 635 to 650 nm.

4. The stamper preform according to Claim 1, comprising a protective film provided on the prebaked resist layer.

5. A method of producing a stamper preform, comprising:
a step of polishing and cleaning at least one surface of a base;
a step of forming a semi-crosslinked resist layer on the at least one surface thus polished or cleaned; and
a step of forming a prebaked resist layer comprising a compound represented by Formula (1) below, on the semi-crosslinked resist layer.

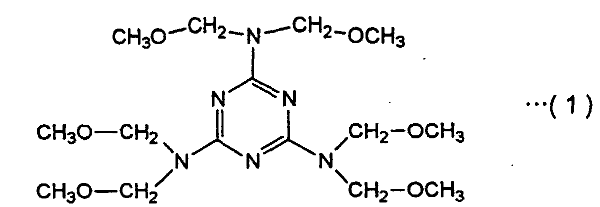

6. The method according to Claim 5, comprising a step of forming a protective film on the prebaked resist layer, after execution of the step of forming the prebaked resist layer.

7. A stamper comprising:
a base; and
a bump provided on the base and comprising as a monomer unit a compound represented by Formula (1) below.

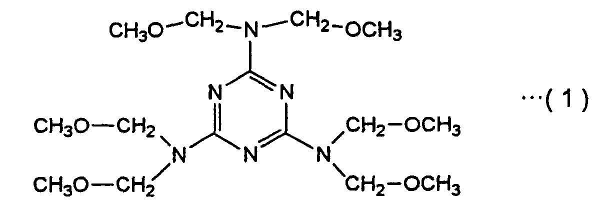

8. A method of producing a stamper, comprising:
a step of recording given information in a prebaked resist layer in a stamper preform comprising a base, and a semi-crosslinked resist layer, and the prebaked resist layer containing a compound represented by Formula (1) below, which are provided on the base;
a step of developing the prebaked resist layer with the information recorded therein, to form a bump; and
a step of inducing a crosslinking reaction in the semi-crosslinked resist layer and in the bump to substantially completely cure the semi-crosslinked resist layer and the bump.

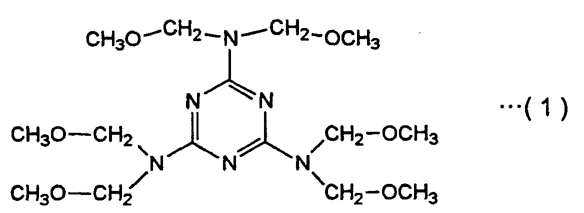

9. An optical disk in which given information recorded in a stamper comprising a base, and a bump provided on the base and comprising as a monomer unit a compound represented by Formula (1) below, is transcribed.
